# EUROPEAN PATENT APPLICATION

(11) **EP 2 423 614 A1**
(43) Date of publication of application: **29.02.2012**
(21) Application number: 11177967.4
(22) Date of filing: 18.08.2011
(51) Int. Cl.: F24F 5/00, F24F 11/00, F24F 12/00

(54) **Air handling unit**

(30) Priority: 26.08.2010 GB 1014260
(71) Applicant: Laing O'Rourke Plc, Dartford, Kent DA2 6SN (GB)
(72) Inventor: Watts, Bob, Manchester, M15 5QJ (GB)
(74) Representative: Cookson, Barbara Elizabeth

(57) **Abstract**

An air handling unit (2) uses at least one or more plate heat exchangers (28, 30) which receive their cooling air supplies in parallel from a low level fresh air supply which can be adiabatically cooled to maximise efficiency. The recirculated air from sealed ductwork at a high level in a data room is cooled by the plate heat exchangers in series.

## Description

### Background of the Invention

The present invention relates to cooling systems and more specifically to air handling units (AHU) for cooling systems of data rooms or halls or other plant rooms. Data rooms house racks of equipment, such as computer servers and storage, which generate much waste heat. The housed equipment typically also has its own internal cooling systems which output heat energy into the room.

### Technical Field

Conventional data room cooling has been done with CRAC units using chilled water or direct expansion refrigeration systems. These are power hungry. In recent years the control temperature for data rooms has increased from 21°C to 27°C which has meant outside air can be used for cooling. When full fresh air cooling has been adopted, this has lead to large contamination problems from the outside air such as odours and smoke. Since the air in a data room must be filtered to remove dust and pollen which would damage the equipment, data room filtration maintenance is also a significant issue if outside air is used.

It is therefore desirable to cool and recirculate the already filtered air from the data room rather than replace it. Thermal wheels have been used as one solution to allow air to be recirculated. Thermal wheels have leakage problems across the wheel where contamination of outside air can take place across the wheel and into the building. Plate heat exchangers have also been employed to transfer heat from recirculated air with a cooling air supply.

The Air Handling Units manufactured under the brand name ADIAVENT (RTM) by Hoval use such an approach together with adiabatic cooling to cool outside air which, in turn, cools inside air via a plate heat exchanger to deliver comfort cooling. Hoval suggest using a second heat exchanger as a pre-cooler for the cooling air. This method is described in W02004/048859 (10 June 2004) also published as US2006118979 ( 8 June 2006). Hoval teaches the use of blowers to circulate the air between the exchangers and is therefore not chosen as the closest prior art.

### Solution of the Invention

The present invention provides an air handling unit for a cooling system for a data room, the unit having a fresh air intake at a low level to supply cooling air to a plate heat exchanger through a first airflow path including a filter and wetted media to increase the relative humidity of the cooling air and cool that cooling air adiabatically; a discharge of the plate heat exchanger being at a higher level in the unit than the fresh air intake; and a duct connection to the unit above the fresh air intake for receiving heated air from the data room to feed through the plate heat exchanger.

Although units using only one plate heat exchanger are satisfactory, if greater cooling is needed, the air handling unit of the present invention may use two or more plate heat exchangers which receive their cooling air supplies in parallel from a fresh air intake. The recirculated air is cooled by the plate heat exchangers in series.

The fresh air intake preferably passes through a wetted media so that it can be adiabatically cooled by evaporation prior to being drawn up into the plate heat exchangers in order to maximise efficiency, but an alternative airflow path may be provided.

Preferably the water used for the wetted media is harvested from the building's rain water guttering system. It can be kept in a storage tank and pumped to the wetted media. This will only require topping up from stored mains water in times of extended drought.

The invention also provides a cooling system comprising an air handling unit of the invention, and a water harvesting system for collecting rain water falling on the building into storage tanks and a pump for delivering it to the unit to wet the media in the unit.

### Brief Description of the Drawing

In order that the invention may be well understood, an embodiment thereof will now be described , by way of example only, with reference to the accompanying diagrammatic drawing in which shows a diagrammatic view of the components of an air handling unit for a data room cooling system.

### Mode for Carrying out the Invention

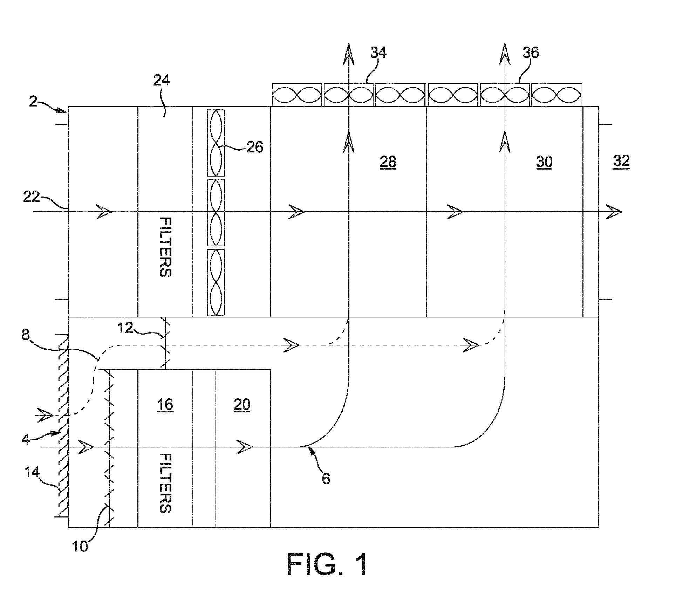

The air handling unit 2 shown in Figure 1 is mounted outside a data room and connects to high sealed ductwork within the room. The unit provides for full recirculation of the air in the ductwork. The embodiment described is for a data room. However it will be appreciated that the unit and this system of cooling can be adopted for any machine room or process room including nuclear power stations where the room temperature can be above 25°C for northern Europe. Lower room temperatures can be achieved when maximum ambient temperatures are lower such as in Iceland.

The unit 2 has a low level fresh air intake 4 that allows fresh air to travel along either a first airflow path 6 or second or bypass airflow path 8. The path taken by the air is controlled by the setting of dampers 10, 12 within each path. Louvers 14 are positioned at the air intake 4 to block entry of large debris. When the outside air is below 20°C the main damper 10 is closed and the bypass damper 12 to the bypass air flow path is opened. When air flows along the main or first airflow path it passes through the damper 10 and through filters 16 and also through wetted media 20 to increase the relative humidity of the air discharged. The water in the moist air in the lower part of the unit 2 evaporates resulting in adiabatic cooling. The cooled air provides the input air for plate heat exchangers mounted above.

A duct 22 which delivers hot air heated through the ductwork from the air in the data room is connected to the unit 2 above the fresh air intake 4. This air for recirculation through the sealed ductwork passes through filters 24 and through fan units 26 which draw the air into a first plate heat exchanger 28 and then through a second plate heat exchanger 30 to a discharge duct 32 which supplies the cooled air to the sealed ductwork in the data room.

Air from the air intake 4 is drawn up through the plate heat exchangers 28,30 by discharge fan units 34, 36 mounted above the plate heat exchangers. The fresh air from below is therefore being taken by the plate heat exchangers in parallel. In alternative embodiments the whole of the heat exchangers do not need to be spaced above the air intake provided that air flow from the intake to a discharge of the plate heat exchanger is generally upward with the discharge being above the intake. This allows a vertically down data hall recirculation air path, with horizontal fresh air path then the fresh air path turned upward for vertical discharge above the air intake.

Further plate heat exchangers may be connected in series or parallel with the first and second plate heat exchangers to provide additional cooling. All of these plate heat exchangers could be arranged in an array above the air intake receiving their cooling air in parallel from a common intake 4.

The ductwork for the cooling air in the data room can run at a high level to take advantage of the hot air rising from the fans of the equipment within the room and of cooling systems that may be provided in the racking installed in the room.

Using this unit, no contaminated outside air can get into the room and the room humidity level can be maintained.

The water harvesting is a separate system as shown in Figure 2. Water from gutters in the building is collected into storage tanks 38 and then pumped to the unit to wet the media 20 in the unit 2.

An example of the plant duty for a site in UK where the maximum peak ambient temperature would be 36°C dry bulb (DB) 23°C wet bulb (WB) is now given. This fresh air intake having a relative humidity (RH) of 12.35% passes through the wetted media and after adiabatic cooling will achieve 23.5°C DB and 23°C WB with an RH of 95.9%. The air flow into the two heat exchangers is 10.1m³/s and 12.41 m³/s respectively.

In the inlet duct 22 air is returned from the data room at 40°C DB and 21.8°C WB with an RH of 19.3%. Downstream of the fan units 26 it will be 41°C DB and 22.1°C WB with an RH of 18.3% as a result of the fan gain. In the first plate heat exchanger 28 the air is cooled to 29.5°C DB and 18.86°C WB with an RH of 34.6%. Air flow of 8 m³/s is equivalent to 105Kw sensible. In the second plate heat exchanger 30 the air is cooled to 25.3°C DB and 17.16°C WB with an RH of 44.3%. The air flow to duct 32 at 8 m³/s is equivalent to 40Kw sensible.

The air discharged from the fan units 34 at the exit of the first plate heat exchanger will be at 37°C DB and 26.69°C WB with an RH of 42.1%. Air flow of 6.57 m³/s is equivalent to 105Kw sensible plus the fan gain. The air discharged from the fan units 36 at the exit of the second plate heat exchanger 30 will be at 28.2°C DB and 24.26°C WB with an RH of 72.6%. Air flow of 8.18 m³/s is equivalent to 40Kw sensible plus the fan gain.

This example uses 1 m³/s as the unit air flow but it will be appreciated that this can vary from 1 m³/s to 30 m³/s and the plant sizes will very in proportion to the airflow.

## Claims

1. An air handling unit (2) for a cooling system for a data room, the unit having a fresh air intake (4) at a low level to supply cooling air to a plate heat exchanger (28) through a first airflow path (6) including a filter (16) and wetted media (20) to increase the relative humidity of the cooling air and cool that cooling air adiabatically; a discharge (32) of the plate heat exchanger (28) being at a higher level in the unit than the fresh air intake; and a duct connection (22) to the unit above the fresh air intake for receiving heated air from the data room to feed through the plate heat exchanger.

2. An air handling unit as claimed in claim 1, wherein there are at least two plate heat exchangers (28, 30) and wherein the duct connection (22) feeds air through the plate heat exchangers in series while the cooling air for the heat exchangers is supplied in parallel from the intake.

3. An air handling unit as claimed in claim 1 or 2, having a second airflow path (8) for intake air wherein air is diverted to the second path if the dry bulb outside temperature is below a predetermined temperature when adiabatic cooling of the air supply to the plate heat exchangers is not required.

4. A cooling system comprising an air handling unit as claimed in any one of the preceding claims, and a water harvesting system for collecting rain water falling on the building into storage tanks 38 and a pump for delivering it to the unit to wet the media in the unit.
